# EUROPÄISCHE PATENTANMELDUNG

(11) **EP 2 101 391 A2**
(43) Veröffentlichungstag der Anmeldung: **16.09.2009**
(21) Anmeldenummer: 09002608.9
(22) Anmeldetag: 25.02.2009
(51) Int. Cl.: H02J 7/35

(54) **Schutzvorrichtung für Solarpanels**

(30) Priorität: 13.03.2008 DE 102008014129
(71) Anmelder: Moeller GmbH, 53115 Bonn (DE)
(72) Erfinder: Borchmann, Oliver, 53913 Swisttal (DE)

(57) **Zusammenfassung**

Die Erfindung löst die Aufgabenstellung, eine sichere Abschaltung der Solaranlage zu gewährleisten, ohne dass ein direkter Zugang zur Solaranlage vorhanden sein muss. Es wird eine Sicherheitsschaltung für Solarpanel (1) vorgeschlagen, wobei das Solarpanel (1) zwei Anschlüsse (11) zu je einer Zuleitung (31) zu einem Verbraucher (3) aufweist, mit einem Bypass (5), welcher zwischen den beiden Anschlüssen (11) und vor den Zuleitungen (31) angeordnet ist und mindestens einen Schließer (23) aufweist. Die Erfindung ist dadurch gekennzeichnet, dass in jeder der beiden Zuleitungen (31) ein Öffner (22) angeordnet ist.

## Beschreibung

Die Erfindung betrifft eine Sicherheitsschaltung für ein Solarpanel. Das Solarpanel weist zwei Anschlüsse zu je einer Zuleitung zu einem Verbraucher auf. Ein Bypass, welcher zwischen den beiden Anschlüssen und vor den Zuleitungen angeordnet ist weist mindestens einen Schließer auf.

Solarpanels werden als Solarenergiequelle eingesetzt und liefern bei Sonneneinstrahlung einen Nutzstrom an angeschlossene Verbraucher. Häufig werden mehrere Solarmodule zu einem Solarpanel zusammengeschlossen und somit der erzeugte Nutzstrom erhöht. Solarpanels werden heute immer häufiger auf privaten und öffentlichen Hausdächern montiert und dienen dann als zusätzliche Energiequelle für private und öffentliche Haushalte.

Im Fall von Wohnungs- oder Hausbränden muss die Feuerwehr dafür sorgen, dass der Einsatzort strom- und spannungslos geschaltet ist, damit zum Beispiel bei Einsatz von Löschmitteln keine Verletzungen durch Stromschläge erfolgen. Damit ein Solarpanel sicher vom Hausnetz genommen werden kann, muss eine Abschaltung direkt am Solarpanel durchgeführt werden, da ansonsten zwischen Zuleitungen immer noch eine Spannung auftreten kann.

Den Einsatzkräften bleibt häufig nicht die Zeit, die Solaranlage auf dem Dach direkt abzuschalten, da häufig der Weg zum Dach versperrt oder die Zeit für eine Abschaltung vom Dach aus zu kurz ist. Typischerweise wird das Hausnetz im Keller durch den Hauptschalter strom- und spannungslos geschaltet. Eine Sicherung des Solarpanels ist dann nicht gewährleistet.

In der US 6,051,954 ist ein Bypass für ein Solarpanel offenbart, welches durch einen Schalter eine Spannungsfreiheit des Solarpanels gewährleistet. Dadurch kann eine Aufladung einer Batterie unterbrochen werden.

Es ist somit Aufgabe der Erfindung, eine sichere Abschaltung der Solaranlage zu gewährleisten, ohne dass ein direkter Zugang zur Solaranlage vorhanden sein muss.

Erfindungsgemäß wird die Aufgabe durch eine Vorrichtung nach Anspruch 1 gelöst. Vorteilhafte Ausführungsformen der Vorrichtung ergeben sich aus den Unteransprüchen.

Die Erfindung betrifft eine Sicherheitsschaltung für ein Solarpanel, wobei das Solarpanel zwei Anschlüsse zu je einer Zuleitung zu einem Verbraucher aufweist, mit einem Bypass, welcher zwischen den beiden Anschlüssen und vor den Zuleitungen angeordnet ist und mindestens einen Schließer aufweist, wobei in jeder der beiden Zuleitungen ein Öffner angeordnet ist.

Es hat sich als besonders vorteilhaft erwiesen, dass der mindestens eine Schließer im Bypass des Solarpanels und die in jeder Zuleitung des Solarpanels befindlichen Öffner gleichzeitig durch ein Betätigungsorgan betätigbar sind.

Vorteilhafterweise sind der mindestens eine Schließer und die Öffner in einem Schütz angeordnet und über ein als Schützrelais ausgeführtes Betätigungsorgan betätigbar.

Eine besonders bevorzugte Ausführungsform zeichnet sich dadurch aus, dass mindestens zwei Schließer im Bypass in Reihe geschaltet sind.

Es hat sich ebenfalls als vorteilhaft erwiesen, dass der Bypass in örtlicher Nähe des Solarpanels angeordnet ist. Dabei ist es besonders vorteilhaft, wenn die Öffner und Schließer mit Ihrem Betätigungsorgan in örtlicher Nähe zu den Anschlüssen des Solarpanels angeordnet sind.

Vorteilhafterweise ist das Betätigungsorgan deutlich entfernt vom Solarpanel ansteuerbar. Eine besondere Ausführungsform der Erfindung zeigt, dass das Betätigungsorgan über einen Not-Aus-Schalter ansteuerbar ist.

Der wesentliche Vorteil der Erfindung besteht in der gleichzeitigen Schaltung der Öffner und Schließer der Sicherheitsschaltung für das Solarpanel. Dies bewirkt zum Beispiel im Falle eines Brandes eine schnelle Abschaltung des Solarpanels vom Hausnetz und den Verbrauchern. Eine Schaltung der Öffner und Schließer über ein Schütz hat zur Folge, dass zum Abschalten des Solarpanels ein als Schützrelais ausgeführtes Betätigungsorgan über einen Not-Aus-Schalter angesteuert werden kann. Der Not-Aus-Schalter kann sich vorteilhafterweise in der Nähe des Hauptschalters der Energieversorgung eines Hause befinden, wobei sich vorteilhafterweise das angesteuerte Schütz in der Nähe des Solarpanels befinden sollte. Dadurch sind die Zuleitungen zwischen Solarpanel und Schütz sehr kurz und stellen nur noch eine sehr geringe Gefährdung durch Spannungsüberschläge dar.

Weitere Vorteile, Besonderheiten und zweckmäßige Weiterbildungen der Erfindung ergeben sich aus den folgenden, anhand von Figuren erläuterten Ausführungsbeispielen Es zeigen:
- Fig. 1: eine schematische Darstellung eines Solarpanels
- Fig. 2: eine schematische Darstellung einer Ausführungsform der erfindungsgemäßen Sicherheitsschaltung
- Fig. 3: eine weitere schematische Darstellung der Ausführungsform der erfindungsgemäßen Sicherheitsschaltung

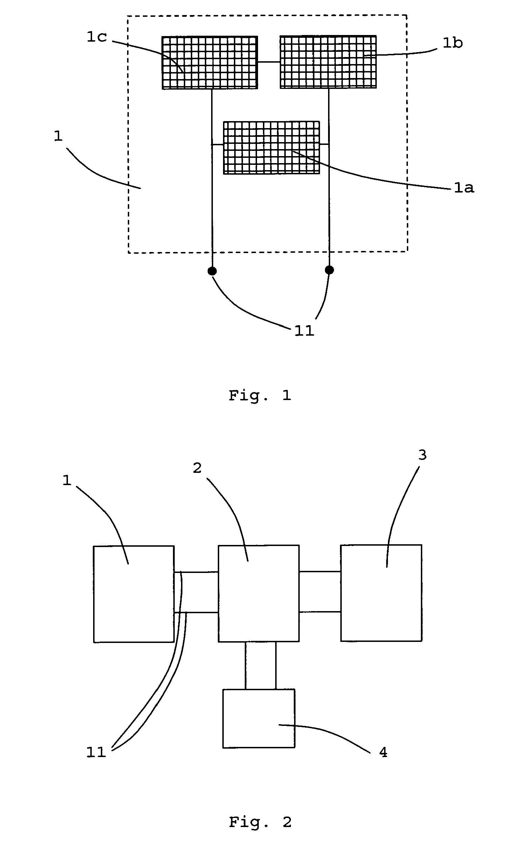

Ein Solarpanel 1 besteht üblicherweise aus mehreren Solarmodulen 1a, 1b, 1c. Fig. 1 offenbart ein Solarpanel 1 mit zwei in Reihe geschalteten Solarmodulen 1b, 1c. Parallel zu den in Reihe geschalteten Solarmodulen 1b, 1c ist ein drittes Solarmodul 1a angeordnet. Alle im Solarpanel befindlichen Solarmodule 1a, 1b, 1c sind über zwei Ausgänge 11 kontaktierbar und liefern bei Sonneneinstrahlung elektrische Energie.

Fig. 2 offenbart eine erfindungsgemäße Schaltung zum sicheren Abschalten des Solarpanels 1. An den Ausgängen 11 des Solarpanels 1, ist ein Schütz 2 in örtlicher Nähe zum Solarpanel 1 angeschlossen. Das Schütz 2 wird über eine Steuereinheit 4 angesteuert, das heisst ein- und ausgeschaltet. Die Steuereinheit 4 kann vorteilhafterweise dort angebracht werden, wo auch die komplette Stromversorgung (zum Beispiel eines Hauses) untergebracht und über Sicherungen und Schalter abgesichert ist. Dies ist häufig ein Kellerraum oder ein extra Schaltraum.
Hinter dem Schütz 2 sind die Verbraucher 3 angeschlossen. Als ein Verbraucher 3 ist hier auch ein meistens notwendiger Wechselrichter anzusehen.

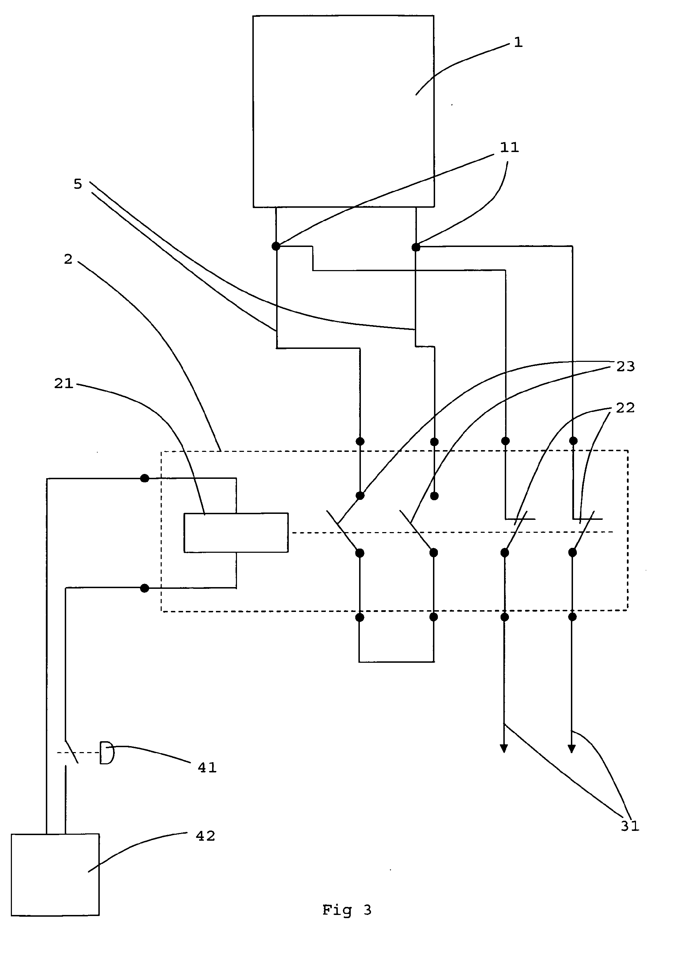

Fig. 3 zeigt einen detailierten Aufbau einer Sicherheitsschaltung. Das Solarpanel 1 ist über Ausgänge 11 mit Hauptanschlüssen eines Schützes 2 verbunden, wobei das Schütz 2 in diesem Ausführungsbeispiel zwei Schließer 23 und zwei Öffner 22 beinhaltet. Schließer 23 sind Kontakte, welche im Ausgangszustand offen stehen und nach Betätigung einen Strompfad schließen. Als Öffner 22 werden hier Kontakte bezeichnet, welche im Ausgangszustand geschlossen sind. Die Öffner 22 und Schließer 23 werden über ein als Schützrelais 21 ausgeführtes Betätigungselement betätigt. Wird das Schützrelais 21 mit Strom versorgt, zieht das Schützrelais 21 an und schließt gleichzeitig die Schließer 23 und öffnet die Öffner 22.

Die Schließer 23 sind parallel zum Solarpanel 1 in einem Bypass 5 verschaltet und schließen das Solarpanel 1 kurz, wenn das Schützrelais 21 angesteuert wird. In diesem Ausführungsbeispiel sind zwei Schließer 23 in Reihe in den Bypass 5 geschaltet. Dadurch wird ein besseres Schliess- und Öffnungsverhalten bewirkt. Da an jedem Schließer nur die halbe Spannung anliegt, wird die Bildung von Lichtbögen erschwert. Es ist möglich, mehr oder weniger als zwei Schließer 23 in den Bypass 5 anzubringen. Dies ist abhängig von der möglichen Ausgangsspannung des Solarpanels 1. Sind die Schließer 23 durch das Schützrelais 21 geschlossen worden, ist das Solarpanel 1 kurzgeschlossen. Durch den Bypass können Ströme bis zu beispielsweise 60A fließen. Die Spannung an den Ausgängen eines Solarpanels für ein Einfamilienhaus kann bis zu beispielsweise 1.000 V betragen. Ströme und Spannungen sind natürlich von der Größe des Solarpanels 1 abhängig. Bei sehr großen Solaranlagen ist es sinnvoll, die Solaranlagen in Bereiche einzuteilen, welche dann jeweils über ein Schütz 2 abschaltbar sind. Somit können die zu schaltenen Ströme relativ klein gehalten werden. Da der Innenwiderstand eines Solarpanels 1 relativ hoch ist, führt der Kurzschluss eines Solarpanels 1 nicht zur Zerstörung des Solarpanels 1.

Zwischen den Ausgängen 11 des Solarpanels 1 und den nachgeschalteten Verbrauchern 3 oder einem nachgeschalteten Wechselrichter ist in jeder Zuleitung 31 ein Öffner 22 vorhanden. In Fig. 3 sind beide Öffner 22 im Schütz 2 integriert und über das Schützrelais 21 betätigbar. Wird das Schützrelais 21 angesteuert, öffnen die Öffner 22 die Strompfade und verhindern das Einspeisen von Strom in das Solarpanel 1 beispielsweise durch eine Batterie.
Durch die gemeinsame Anordnung der Schließer 23 und Öffner 22 in einem Schütz 2 kann durch das Ansteuern des Schützrelais 21 ein gleichzeitiges Öffnen der Öffner 22 und Schließen der Schließer 23 im Bypass 5 realisiert werden. Das Solarpanel 1 ist dann kurzgeschlossen und kann keinen Strom in die Verbraucher einspeisen. Es ist kein Spannungsabfall in den nach dem Schütz 2 angebrachten Zuleitungen 31 mehr möglich.

Damit eine Gefährdung durch Spannungsüberschläge im Falle eines Brandes möglichst verhindert wird, sollten die Leitungen zwischen Solarpanel 1 und Schütz 2 möglichst kurz sein.

Zur Ansteuerung des Schützrelais 21 wird im Ausführungsbeispiel nach Fig. 3 eine externe Hilfsstromversorgung 42 verwendet, welche über einen Not-Aus-Schalter 41 mit dem Schützrelais 21 verbunden ist. Der Not-Aus-Schalter 41 kann zum Beispiel neben den Hauptschalter der Stromversorgung eines Hauses angebracht sein. Damit kann im Falle eines Brandes außer dem Hauptschalter gleichzeitig die Stromversorgung des Solarpanels 1 unterbrochen werden.

### Bezugszeichenliste:

- 1: Solarpanel
- 1a, 1b, 1c: Solarmodul
- 11: Anschluss für Solarpanel

- 2: Schütz
- 21: Schützrelais
- 22: Öffner
- 23: Schließer

- 3: Verbraucher
- 31: Zuleitungen zum Verbraucher

- 4: Steuereinheit
- 41: Not-Aus-Schalter
- 42: Hilfsstromversorgung

- 5: Bypass

## Patentansprüche

1. Sicherheitsschaltung für ein Solarpanel (1), wobei das Solarpanel (1) zwei Anschlüsse (11) zu je einer Zuleitung (31) zu einem Verbraucher (3) aufweist, mit einem Bypass (5), welcher zwischen den beiden Anschlüssen (11) und vor den Zuleitungen (31) angeordnet ist und mindestens einen Schließer (23) aufweist,
**dadurch gekennzeichnet,**
**dass** in jeder der beiden Zuleitungen (31) ein Öffner (22) angeordnet ist.

2. Sicherheitsschaltung nach Anspruch 1
**dadurch gekennzeichnet,**
**dass** der mindestens eine Schließer (23) und die in jeder Zuleitung (31) des Solarpanels (1) befindlichen Öffner (22) gleichzeitig durch ein Betätigungsorgan betätigbar sind.

3. Sicherheitsschaltung nach Anspruch 2,
**dadurch gekennzeichnet,**
**dass** der mindestens eine Schließer (23) und die Öffner (22) in einem Schütz (2) angeordnet sind und über ein als Schützrelais (21) ausgeführtes Betätigungsorgan betätigbar sind.

4. Sicherheitsschaltung nach einem der vorhergehenden Ansprüchen,
**dadurch gekennzeichnet,**
**dass** mindestens zwei Schließer (23) im Bypass (5) in Reihe geschaltet sind.

5. Sicherheitsschaltung nach einem der vorhergehenden Ansprüchen,
**dadurch gekennzeichnet,**
**dass** der Bypass (5) in örtlicher Nähe des Solarpanels (1) angeordnet ist.

6. Sicherheitsschaltung nach einem der vorhergehenden Ansprüche 2 bis 5,
**dadurch gekennzeichnet,**
**dass** die Öffner (22) und Schließer (23) mit Ihrem Betätigungsorgan in örtlicher Nähe zu den Anschlüssen (11) des Solarpanels (1) angeordnet sind.

7. Sicherheitsschaltung nach einem der vorhergehenden Ansprüche 2 bis 6,
**dadurch gekennzeichnet,**
**dass** das Betätigungsorgan deutlich entfernt vom Solarpanel (1) ansteuerbar ist.

8. Sicherheitsschaltung nach einem der vorhergehenden Ansprüchen,
**dadurch gekennzeichnet,**
**dass** das Betätigungsorgan über einen Not-Aus-Schalter (41) ansteuerbar ist.
